# EUROPEAN PATENT APPLICATION

(11) **EP 4 498 358 A1**
(43) Date of publication of application: **29.01.2025**
(21) Application number: 24191381.3
(22) Date of filing: 29.07.2024
(51) Int. Cl.: G10H 1/12, G10H 3/18, H04H 60/04

(54) **SYSTEMS AND METHODS FOR INTRODUCING VARIABILITY INTO DIGITALLY MODELED CIRCUITS**

(30) Priority: 28.07.2023 US 202363529592 P
(71) Applicant: Louder Than Liftoff LLC, Palo Alto, California 94306 (US)
(72) Inventor: McGowan, Bradford, Palo Alto, 94306 (US); Dickinson, Joshua, Palo Alto, 94306 (US)
(74) Representative: 2s-ip Schramm Schneider Bertagnoll Patent- und Rechtsanwälte Part mbB

(57) **Abstract**

A computer-based method is provided for introducing variability into digitally modeled circuits. Such a method includes acquiring a first circuit model corresponding to an audio circuit, identifying, in the first circuit model, at least one component having at least one variable value, identifying a nominal value associated with the at least one variable value of the at least one component, and selecting a first selected component value from a plurality of potential component values associated with the nominal value for the at least one variable value. The first selected component value typically differs from the nominal value. The method further includes incorporating the first selected component value into the first circuit model in place of the nominal value. Audio output is generated by processing audio by way of the first circuit model. Also provided is a system for implementing the method and a corresponding digital emulation.

## Description

### CROSS REFERENCE TO RELATED APPLICATIONS

This application takes priority from US Provisional Application No. 63/529,592 filed July 28, 2023, the entire contents of which are incorporated by reference herein.

### FIELD OF THE INVENTION

The invention is related generally to the field of data processing. More specifically, the present invention relates to introducing variability into digitally modeled circuits, such as emulations of analog audio output in digitally modeled systems.

### BACKGROUND

The field of data processing is technologically important to several industries, business organizations, and/or individuals. In particular, the use of data processing is prevalent for systems and applications for generating digitally modeled audio output, such as in the context of audio plugins.

In modern audio recording studios, computers and digital audio workstations (DAWs) are predominantly used to digitally record and mix audio tracks. Software audio plugins are used on each track to process or add effects to the sound to create a musically pleasing mix. Common plugin formats are AU (Audio Unit plugin interface standard), VST (Virtual Studio Technology plugin interface standard), and AAX (Avid Audio Extension plugin interface standard). Such plugins can typically perform traditional analog processes, such as equalization, compression, limiting, saturation, and distortion, or such plugins can achieve effects that are uniquely suited to the digital domain like reverbs and complex modulations.

Many modern plugins attempt to emulate analog hardware processors by digitally modeling analog circuits using digital signal processing (DSP) techniques. The current state of the art for most analog emulation plugins is to model a single hardware unit-a "golden unit". Oftentimes only one channel of a stereo processor is modeled and the resultant DSP algorithms are identical across multiple channels or instances of the plugin. The reality of analog hardware is that every physical unit is unique due to the stack-up of electronic component tolerances or variations between production runs. Each channel in a stereo or multichannel unit is also unique due to variations in components. In other words, each user receives a unique unit. For example, a dual gang 20k linear pot may measure 19,510 ohms for the first gang, and 20,230 ohms for the second gang. These kinds of variations throughout the entire analog circuit will contribute to slight differences in frequency response, phase response, gain, and distortion for each signal path. In a stereo unit, these subtle differences contribute to a sense of depth, dimension, and nuance.

In analog emulation audio plugins, these variations do not typically exist between channels or individual instances in a way that truly emulates how analog hardware is built and assembled. There have been attempts in the past to model component tolerances with mathematical distributions, but the resulting variations in the DSP are limited to a finite number of unique instances and are theoretical at best. Furthermore, these algorithms yield static emulations that do not allow for dynamic, hyper-realistic versions of the digital model.

Therefore, there is a need for improved systems for generating digitally modeled analog realism for audio plugins that may overcome one or more of the above-mentioned problems and/or limitations.

### SUMMARY

In some embodiments, a computer-based method is provided for introducing variability into digitally modeled circuits. Such a method includes acquiring a first circuit model corresponding to an audio circuit, identifying, in the first circuit model, at least one component having at least one variable value, identifying a nominal value associated with the at least one variable value of the at least one component, and selecting a first selected component value from a plurality of potential component values associated with the nominal value for the at least one variable value. The first selected component value typically differs from the nominal value.

The method further includes incorporating the first selected component value into the first circuit model in place of the nominal value. The method further typically includes generating an audio output at least partially by processing audio by way of the first circuit model.

In some embodiments, the at least one component is a resistor, capacitor, potentiometer, diode, transistor, voltage-controlled amplifier, transformer, or vacuum tube. In some such embodiments, the at least one component is a plurality of components, each associated with an identical nominal value, and a different component value is selected for each of the plurality of components.

In some embodiments, the at least one component is a plurality of components, each associated with different nominal values, and for each component of the plurality of components, a component value is selected from a different plurality of potential component values associated with the corresponding nominal value.

In some embodiments, the at least one component is a potentiometer, and the at least one variable value is a plurality of variable values, wherein the plurality of variable values define detent locations or resistor values associated with corresponding detent locations. In some such embodiments, the component values assigned to such variable values define a taper such that minimal resistance is nominally at one end and maximum resistance is nominally at the other end.

In some embodiments, the at least one component is non-linear with a behavior defined by a sub-model having at least one internal variable value, and the selected nominal value is associated with an internal variable value of the sub-model.

In some embodiments, the method further includes providing a plurality of databases or data structures, each containing a plurality of potential component values associated with a given nominal value. A selection of a first of the plurality of databases or data structures or a second of the plurality of databases or data structures is then based on a system setting.

In some such embodiments, the first of the plurality of databases or data structures corresponds to an A-stock parts database or data structure and wherein the second of the plurality of databases or data structures corresponds to a B-stock parts database or data structure, and the A-stock parts database or data-structure provides potential component values for emulated components with tighter tolerances than the potential component values of the B-stock parts database or data-structure.

In some embodiments, the method includes retrieving a plurality of physical components corresponding to the at least one component having at least one variable value and manufactured in accordance with the nominal value. The method then proceeds with measuring actual values associated with the plurality of physical components and populating the plurality of potential component values based on the actual values measured.

In some such embodiments, the populating of the plurality of potential component values based on the actual values measured further includes generating a part value distribution model based on the actual values measured and extrapolating a larger plurality of potential component values than those actually measured.

In some embodiments, the method further includes acquiring a device model comprising a plurality of circuit models, each corresponding to one of a plurality of audio channels. The first circuit model is then one of the plurality of circuit models, and a second circuit model of the plurality of circuit models is identical to the first circuit model.

The method then proceeds with identifying, in the second circuit model, at least one component having at least one variable value, the at least one component of the second circuit model corresponding to the at least one component of the first circuit model, identifying the nominal value associated with the at least one variable value, and selecting a second selected component value from the plurality of potential component values associated with the nominal value, where the second selected component value differs from the nominal value.

The method then proceeds with incorporating the second selected component value into the second circuit model in place of the nominal value and, typically, generating an audio output by processing audio by way of the second circuit model.

In some such embodiments, a user setting determines whether the second selected component value is identical to the first selected component value.

In some embodiments, the method further includes identifying at least one additional component having at least one variable value and for each variable value identified, identifying a nominal value associated with the corresponding variable value, selecting a component value for the corresponding variable value from a plurality of potential component values associated with the nominal value, and incorporating the corresponding selected component value into the first circuit model in place of the nominal value.

Following the incorporation of selected component values into the first circuit model, all variable values are provided with corresponding component values.

In some such embodiments, the method further includes generating a virtual serial number associated with the first circuit model, the virtual serial number corresponding to an implementation of the first circuit model incorporating all selected component values. The virtual serial number is then usable to generate an identical implementation of the first circuit model in multiple implementations of software utilizing the computer-based method.

In some embodiments in which all variable values are provided with corresponding component values, the method further includes retrieving a virtual serial number and utilizing the serial number to select the component values from the corresponding pluralities of potential component values for each variable value.

In some such embodiments, the virtual serial number is used as a seed for a pseudo-random number generator which in turn generates a map of indices by which the component values are selected.

In some embodiments, the first selected component value is a dynamic function of time. In some such embodiments, the dynamic function of time is based on an oscillation generator.

In some embodiments in which the first selected component value is a dynamic function of time, the dynamic function of time emulates thermal effects or component aging associated with use of a corresponding analog audio circuit.

In some embodiments, the first selected component value fluctuates pseudo-randomly. In some such embodiments, the first selected component value fluctuates at least partially based on the generated audio output.

Also provided is a system for introducing variability into digitally modeled circuits. Such a system includes a memory for storing a plurality of instructions and at least one circuit model, processing circuitry for implementing a first circuit model of the at least one circuit model, an audio output for outputting audio generated by the first circuit model, and a plurality of databases or data structures, each database or data structure corresponding to a nominal value for a circuit component and comprising a plurality of potential component values for a corresponding variable.

During use, the processing circuitry couples with the memory and the plurality of databases or data structures, and is configured to identify, in the first circuit model, at least one component having at least one variable value, identify a nominal value associated with the at least one variable value of the at least one component, select a database or data structure based on the identified nominal value, select a first selected component value from the plurality of potential component values in the selected database or data structure, and incorporate the first selected component value into the first circuit model in place of the nominal value.

The audio generated by the first circuit model is then at least partially based on the first selected component value.

Also provided is a digital emulation of an analog device recorded on computer readable media. Such a digital emulation includes a circuit model corresponding to an analog audio component, the circuit model having a plurality of modeled analog components, where a first modeled analog component of the plurality of modeled analog components has a corresponding first nominal value and where a second modeled analog component of the plurality of modeled analog components has a corresponding second nominal value.

The digital emulation further includes a first group of predefined potential component values associated with the first nominal value and a second group of predefined potential component values associated with the second nominal value, and an audio plugin for processing sounds using the circuit model.

The first modeled analog component is assigned a value selected from the first group and the second modeled analog component is assigned a value selected from the second group, and audio output by the audio plugin utilizes the assigned values of the first and second modeled analog components.

### BRIEF DESCRIPTION OF THE DRAWINGS

Figure 1 illustrates an online platform consistent with various embodiments of the present disclosure.
Figure 2 is a block diagram of a computing device for implementing the methods disclosed herein, in accordance with some embodiments.
Figure 3 is a flowchart illustrating a computer-based method for emulating analog audio output.
Figures 4A and 4B are examples of analog circuits to be emulated using the systems and methods shown.
Figure 5 is an illustration of a system for generating emulated analog audio in the context of audio plugins, in accordance with this disclosure.

### DETAILED DESCRIPTION OF THE PREFERRED EMBODIMENTS

The description of illustrative embodiments according to principles of the present invention is intended to be read in connection with the accompanying drawings, which are to be considered part of the entire written description.

The features and benefits of the invention are illustrated by reference to the exemplified embodiments. Accordingly, the invention expressly should not be limited to such exemplary embodiments illustrating some possible non-limiting combination of features that may exist alone or in other combinations of features; the scope of the invention being defined by the claims appended hereto.

This disclosure describes the best mode or modes of practicing the invention as presently contemplated. This description is not intended to be understood in a limiting sense, but provides an example of the invention presented solely for illustrative purposes by reference to the accompanying drawings to advise one of ordinary skill in the art of the advantages and construction of the invention. In the various views of the drawings, like reference characters designate like or similar parts.

Accordingly, it will readily be understood by one having ordinary skill in the relevant art that the present disclosure has broad utility and application. As should be understood, any embodiment may incorporate only one or a plurality of the aspects of the disclosure and may further incorporate only one or a plurality of the disclosed features. Furthermore, any embodiment discussed and identified as being "preferred" may be considered to be part of a best mode contemplated for carrying out the embodiments of the present disclosure. Other embodiments also may be discussed for additional illustrative purposes in providing a full and enabling disclosure. Moreover, many embodiments, such as adaptations, variations, modifications, and equivalent arrangements, will be implicitly disclosed by the embodiments described herein and fall within the scope of the present disclosure.

Accordingly, while embodiments are described herein in detail in relation to one or more embodiments, it is to be understood that this disclosure is illustrative and exemplary of the present disclosure, and are made merely for the purposes of providing a full and enabling disclosure. The detailed disclosure herein of one or more embodiments is not intended, nor is to be construed, to limit the scope of patent protection afforded in any claim of a patent issuing here from, which scope is to be defined by the claims and the equivalents thereof. It is not intended that the scope of patent protection be defined by reading into any claim a limitation found herein that does not explicitly appear in the claim itself.

Thus, for example, any sequence(s) and/or temporal order of steps of various processes or methods that are described herein are illustrative and not restrictive. Accordingly, it should be understood that, although steps of various processes or methods may be shown and described as being in a sequence or temporal order, the steps of any such processes or methods are not limited to being carried out in any particular sequence or order, absent an indication otherwise. Indeed, the steps in such processes or methods generally may be carried out in various different sequences and orders while still falling within the scope of the present invention. Accordingly, it is intended that the scope of patent protection is to be defined by the issued claim(s) rather than the description set forth herein.

Additionally, it is important to note that each term used herein refers to that which an ordinary artisan would understand such term to mean based on the contextual use of such term herein. To the extent that the meaning of a term used herein-as understood by the ordinary artisan based on the contextual use of such term-differs in any way from any particular dictionary definition of such term, it is intended that the meaning of the term as understood by the ordinary artisan should prevail.

Furthermore, it is important to note that, as used herein, "a" and "an" each generally denotes "at least one," but does not exclude a plurality unless the contextual use dictates otherwise. When used herein to join a list of items, "or" denotes "at least one of the items," but does not exclude a plurality of items of the list. Finally, when used herein to join a list of items, "and" denotes "all of the items of the list."

The following detailed description refers to the accompanying drawings. Wherever possible, the same reference numbers are used in the drawings and the following description to refer to the same or similar elements. While many embodiments of the disclosure may be described, modifications, adaptations, and other implementations are possible. For example, substitutions, additions, or modifications may be made to the elements illustrated in the drawings, and the methods described herein may be modified by substituting, reordering, or adding stages to the disclosed methods. Accordingly, the following detailed description does not limit the disclosure. Instead, the proper scope of the disclosure is defined by the appended claims. The present disclosure contains headers. It should be understood that these headers are used as references and are not to be construed as limiting upon the subjected matter disclosed under the header.

The present disclosure includes many aspects and features. Moreover, while many aspects and features relate to, and are described in the context of systems for generating digitally modeled analog realism for audio plugins, embodiments of the present disclosure are not limited to use only in this context.

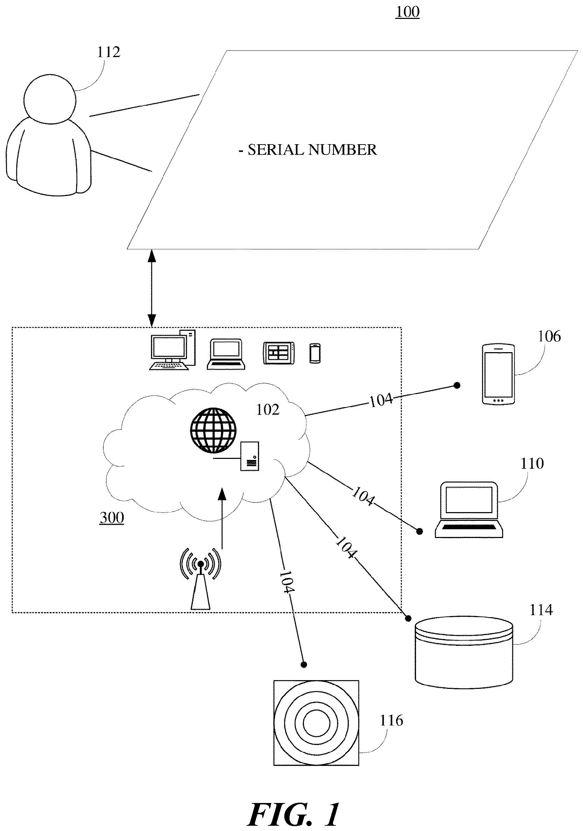

Figure 1 illustrates an online platform consistent with various embodiments of the present disclosure and FIG. is a block diagram of a computing device for implementing the methods disclosed herein, in accordance with some embodiments.

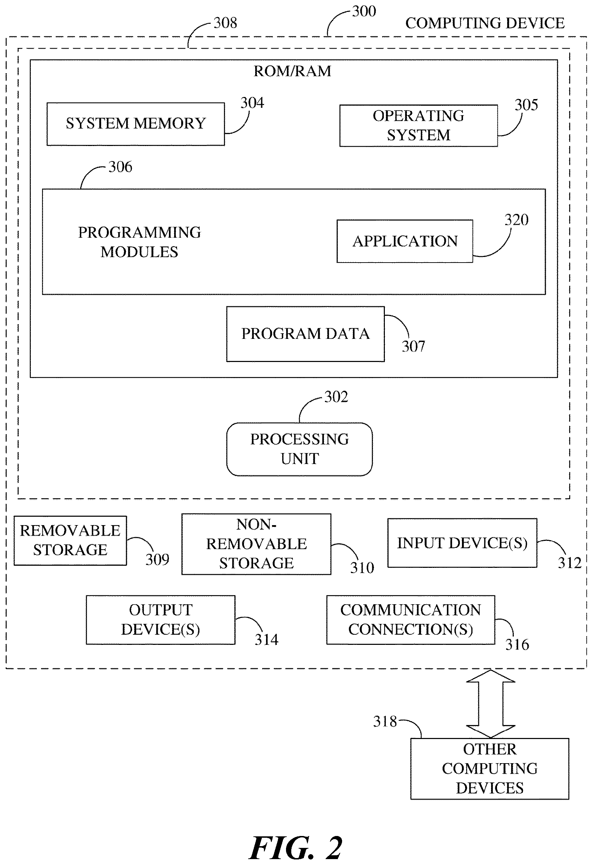

Figure 2 is an illustration of an online platform 100 consistent with various embodiments of the present disclosure. By way of non-limiting example, the online platform 100 may be used to generate and implement a digital model of an analog device to be emulated. Such an emulation may be in the context of an audio plugin, which may be hosted on a centralized server 102, such as, for example, a cloud computing service.

The centralized server 102 may communicate with other network entities, such as, for example, a mobile device 106 (such as a smartphone, a laptop, a tablet computer, etc.), other electronic devices 110 (such as desktop computers, server computers, etc.), databases 114, sensors 116, over a communication network 104, such as, but not limited 20 to, the Internet. Further, users of the online platform 100 may include relevant parties such as, but not limited to, end-users, content creators, and administrators. Accordingly, in some instances, electronic devices operated by the one or more relevant parties may be in communication with the online platform 100.

A user 112, such as the one or more relevant parties, may access the online platform 100 through a web-based software application or browser. The web-based software application may be embodied as, for example, but not be limited to, a website, a web application, a desktop application, and a mobile application compatible with a computing device 300.

With reference to FIG. 2, a system consistent with an embodiment of the disclosure may include a computing device or cloud service, such as computing device 300. In a basic configuration, computing device 300 may include at least one processing unit 302 and a system memory 304. Depending on the configuration and type of computing device, system memory 304 may comprise, but is not limited to, volatile (e.g., random-access memory (RAM)), non-volatile (e.g., read-only memory (ROM)), flash memory, or any combination. System memory 304 may include operating system 305, one or more programming modules 306, and may include a program data 307. Operating system 305, for example, may be suitable for controlling computing device 300's operation. In one embodiment, programming modules 306 may include image-processing module, machine learning module and/or image classifying module. Furthermore, embodiments of the disclosure may be practiced in conjunction with a graphics library, other operating systems, or any other application program and is not limited to any particular application or system. This basic configuration is illustrated in FIG. 2 by those components within a dashed line 308.

Computing device 300 may have additional features or functionality. For example, computing device 300 may also include additional data storage devices (removable and/or non-removable) such as, for example, magnetic disks, optical disks, or tape. Such additional storage is illustrated in FIG. 2 by a removable storage 309 and a non-removable storage 310. Computer storage media may include volatile and nonvolatile, removable and non-removable media implemented in any method or technology for storage of information, such as computer-readable instructions, data structures, program modules, or other data. System memory 304, removable storage 309, and non-removable storage 310 are all computer storage media examples (i.e., memory storage). Computer storage media may include, but is not limited to, RAM, ROM, electrically erasable read-only memory (EEPROM), flash memory or other memory technology, CD-ROM, digital versatile disks (DVD) or other optical storage, magnetic cassettes, magnetic tape, magnetic disk storage or other magnetic storage devices, or any other medium which can be used to store information and which can be accessed by computing device 300. Any such computer storage media may be part of device 300. Computing device 300 may also have input device(s) 312 such as a keyboard, a mouse, a pen, a sound input device, a touch input device, a location sensor, a camera, a biometric sensor, etc. Output device(s) 314 such as a display, speakers, a printer, etc. may also be included. The aforementioned devices are examples and others may be used. Computing device 300 may also contain a communication connection 316 that may allow device 300 to communicate with other computing devices 318, such as over a network in a distributed computing environment, for example, an intranet or the Internet. Communication connection 316 is one example of communication media. Communication media may typically be embodied by computer-readable instructions, data structures, program modules, or other data in a modulated data signal, such as a carrier wave or other transport mechanism, and includes any information delivery media. The term "modulated data signal" may describe a signal that has one or more characteristics set or changed in such a manner as to encode information in the signal. By way of example, and not limitation, communication media may include wired media such as a wired network or direct-wired connection, and wireless media such as acoustic, radio frequency (RF), infrared, and other wireless media. The term computer-readable media as used herein may include both storage media and communication media.

As stated above, a number of program modules and data files may be stored in system memory 304, including operating system 305. While executing on processing unit 302, programming modules 306 (e.g., application 320 such as a media player or an audio plugin) may perform processes including, for example, one or more stages of methods, algorithms, systems, applications, servers, databases as described above. The aforementioned process is an example, and processing unit 302 may perform other processes. Other programming modules that may be used in accordance with embodiments of the present disclosure may include sound encoding/decoding applications, machine learning application, acoustic classifiers, etc.

The present disclosure describes systems and methods for introducing variability into digitally modeled circuits. A typical implementation would be generating emulated analog output in a digital system. Such systems and methods may be used for digitally modelling analog realism into, e.g., audio plugins. It will be understood that while implementations discussed herein generally relate to emulating analog hardware and corresponding variability in analog components. However, any variable in digital signal processing (DSP) code, whether it's meant to emulate an analog circuit or not, could be modified in the various ways discussed below. Accordingly, the methodology disclosed herein could similarly be used to introduce static or dynamic variation or other forms of variance into audio DSP.

Further, the disclosed system brings an advanced level of analog realism and hyperrealism to digitally modeled analog emulation audio plugins (mono, stereo, or multi-channel). Further, the system may be configured for generating a near-infinite number of unique plugin instances with accurate channel-to-channel, and instance-to-instance variations (or variations). Further, the system may include virtual circuit components used by a DSP model to build unique versions/instances of the plugin for each user incorporating the variations. Further, the system may link unique builds of the plugin to a user license.

Further, critical circuit components (or components) driving variation in real hardware units may be identified and cataloged into a virtual parts bin system. Further, the components may include resistors, potentiometers, capacitors, diodes, transistors, voltage-controlled amplifiers (or VCA), transformers, and vacuum tubes. Further, values of each critical component may be measured or empirically determined from real part specimens for increased authenticity. In the case of more complex non-linear parts like transformers and vacuum tubes, the value used may be in the context of analytically generated sub-models instead of a discrete integer value. Variation may be added to internal variables within the sub-model. Multiple values for each nominal component may be entered into arrays that may be accessed by the system or method.

As discussed in more detail below, multiple "virtual parts bins" may be provided. As such, a user-chosen mode of the system may specify which virtual parts bins are used to randomly select part values for critical variables in the digital model based on the analog circuit. The set of all selected component variable values may be linked to the user plugin license associated with a user via a virtual serial number. This may then create a unique "build" for each user similar to the experience with real analog hardware.

It is important to note that there is no limit to the number of virtual parts bins or the number of values in each array that may be specified. Greater numbers of each may yield more unique build permutations.

For example, there is a 100 µF capacitor used in 17 places throughout the model. The virtual parts bin for 100 µF capacitors may then contain an array of 10 values: 101, 102, 104, 101, 106, 100, 102, 102, 100, and 103. The system then selects one of those ten values for each variable requiring a 100 µF part. Where a virtual serial number has been assigned to the user, such selection may be performed using a unique parts map that has been calculated for the user's serial number. This may be repeated for each variable requiring a virtual parts bin component value. Depending on the number of virtual parts bins and the number of discrete values in each, there may be hundreds of thousands, or millions of unique permutations created in the model.

Further, hardware pro audio processors are often serialized when they are assembled during manufacturing. Each serial number may help to identify information about the product like production run/batch number, date of manufacture, traceability of key components (e.g., circuit boards), or other unique features that might distinguish it from other units. In a similar manner, the analog realism generator uses a virtual serial number system to identify unique sets of variables that affect the static and dynamic behavior of the digital model when the plugin is instantiated. A random serial number (and associated "build") may then be assigned to each user by associating it to their plugin license code. This original issue serial number is the default and instructs the system and method how to use the Virtual Parts Bins to assign deterministic values for each component variable in the model.

Further, a text field in the plugin GUI may contain a string of characters that represents the serial number. This string may be any combination of letters and numbers of any length to establish the maximum limit of possible unique model permutations. The maximum number of permutations may be different from the number of permutations governed by the virtual parts bin if desired. In some embodiments, the user may overwrite this number with any new serial number that conforms to the constraints of the text field. If a new serial number is entered, then the analog realism generator creates a new build of the model assigning component values from the virtual parts bins accordingly. The user may establish any serial number as a new default by choosing an option from the plugin's menu. For example, the user is originally issued serial number 10465. Further, the user may change the serial number to 33176 and choose the option to make this the new default. The next instance of the plugin added to a digital audio workstation (DAW) session may use serial number 33176.

If a user starts a new DAW session, then 33176 may also be used. Further, the system may provide a menu option that lets the user restore the serial number to the originally issued number. By default, each time the plugin is instantiated the same serial number may be used to build the model. In a mixing scenario, this may mean that the plugin behaves identically every time it is used in a mix. However, this behavior may also be configured so that each instantiation automatically yields a new unique serial number. In the real world, this may be analogous to having multiple examples of a processor in the studio rack, where each unit will vary slightly from the others in its sonic performance.

The use of an explicit static virtual parts bin and a component map that is calculated only once when a serial number is changed reduces CPU consumption compared to other forms of tolerance modeling, such as the use of randomized offsets or distributions where component values need to be calculated for every plugin instance. This reduction in CPU consumption allows for more simultaneous instances and unique builds.

Further, a plugin GUI may include user-selectable options that control variation introduced into the emulation. This gives the user a spectrum of analog realism to explore. At one end of the spectrum, there may be minimal variation and the model is static, wherein components may be idealized for repeatability and sameness between plugin channels and instances. At the other end, there is dynamic variation and variable values are changing over time in complex relationships with one another. Further, options may control whether two or more channels use identical component values in the digital model of the analog circuit, which parts of the digital model are using the virtual parts bins vs. using nominal or idealized circuit values, which virtual parts bins are used for a given variable, whether the variables in the model use static values or dynamic values that change over time, the time-based relationships and functions modulating variables with dynamic values, whether variables unrelated to the virtual parts bins have variation (i.e., they deviate from their default values).

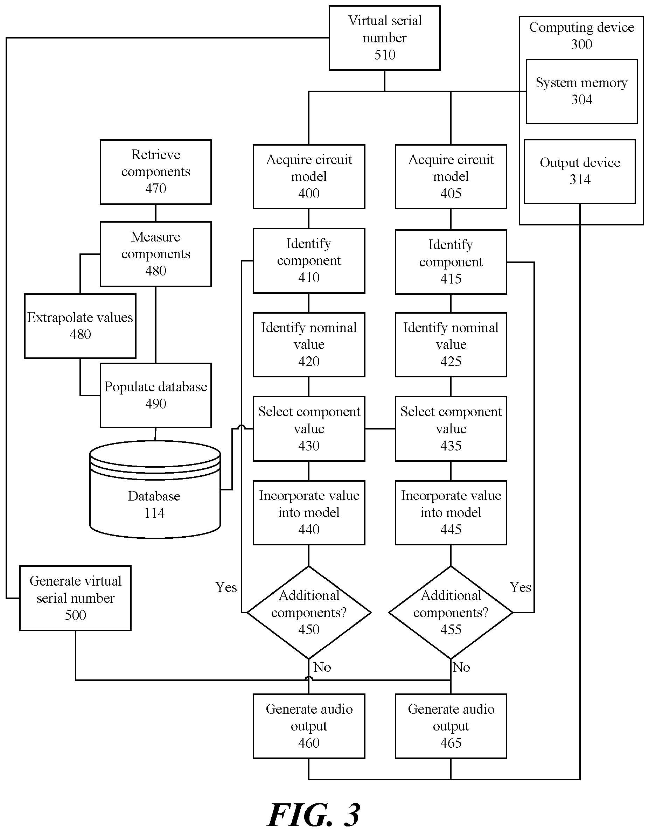

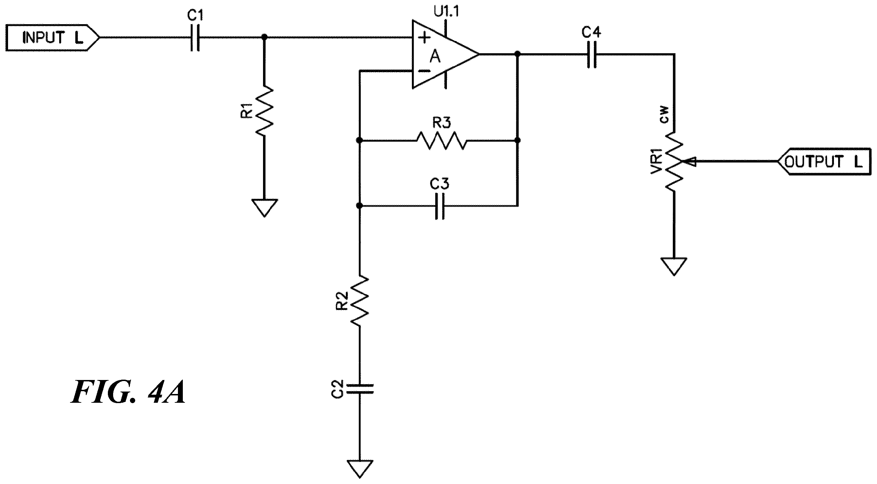

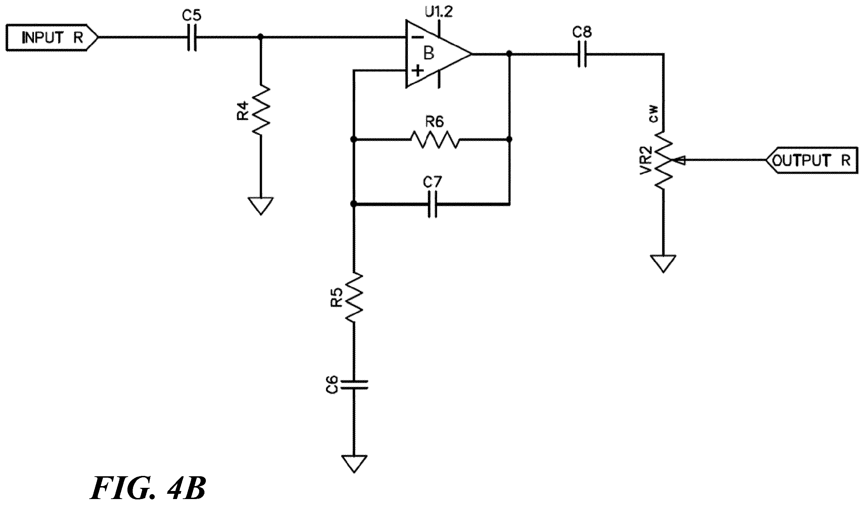

Figure 3 is a flowchart illustrating a computer-based method for emulating analog audio output. Such an emulation may be implemented on the computing device 300 of FIG. 2, or it may be implemented in the context of an online platform 100, such as that presented in FIG. 1. Examples of first and second circuits in the context of the method described are shown in FIGS. 4A and 4B.

As shown, the computer-based method of emulating analog audio includes first acquiring a first circuit model corresponding to an audio circuit (400). Such a circuit model may be a generic implementation of an audio device, such as, e.g., an audio amplifiers, mixers, etc. such implementations may provide a single audio channel, or they may provide two or more audio channels to provide, e.g., stereo sound. An example of such a circuit model is shown in FIG. 4A.

Further, such a circuit model may be a specific implementation of an audio device, such as a real-world amplifier or mixer. For example, a circuit model may emulate a well-known circuit associated with particular audio characteristics. As another example, a manufacturer may provide a physical analog amplifier, and may wish to provide a realistic emulation of the same circuit to users under the same brand. Such an emulation may then be used by a user in place of the original analog circuit, or it may be used alongside the analog circuit.

A system implementing such a method for emulating analog audio typically comprises a system memory 304 for storing a plurality of instructions, at least one circuit model, and software designed for emulating a circuit modeled in accordance with the method described. The system may further include processing circuitry, such as a processing unit 302, for implementing the circuit model, an audio output 314 for outputting audio generated by way of the emulated audio circuit, and a plurality of databases or data structures 114. Each database or data structure may then correspond to a nominal value for a circuit component and may comprise a plurality of potential component values for a corresponding variable, as discussed in more detail below.

In any event, such a circuit model may be acquired (400) in a number of ways. It may be a specific circuit model provided as part of a software package for emulating analog audio, and during use, it may then be drawn from system memory 304. Alternatively, a plugin or software package provided to a user may allow a user to choose one of several available circuit models, which may be either in system memory 304, or it may be drawn from a database 114 accessed over a network 104. Such a circuit model may have a single audio channel or multiple audio channels.

The method then proceeds to identify (410), in the circuit model, at least one component having a variable value. Such a component is an analog component of the audio circuit, such as a resistor, capacitor, potentiometer, diode, transistor, voltage-controlled amplifier, transformer, or vacuum tube. Such components may be assigned a nominal value, but manufactured implementations of such components will typically vary relative to the nominal value.

Accordingly, once the component is identified (410), a corresponding nominal value associated with the variable value is identified (420). Accordingly, a resistor, for example, may be identified as the component having a variable value (at 410). In a particular instance in the circuit model, the resistor may be identified as having a nominal value of 1000 Ohms (at 420).

Once a nominal value is identified for a specific component (at 420), a corresponding component value may be selected (430) from a plurality of potential component values associated with that particular nominal value. The selected component value may then differ from the nominal value. Such a plurality of potential component values may be stored in a data structure, such as an array or matrix in a database associated with the circuit model or the plugin software.

Accordingly, a database or data structure may be provided in which a variety of potential component values are associated with each potential nominal value, such that the database can be used as a virtual parts bin. In this way, for any given nominal value, the method may extract a component value from the corresponding data structure. The selection of a database or data structure from which to draw an appropriate potential component value may then be based on the identified nominal value.

In the example given above, where a nominal value for a resistor is 1000 Ohm, the data structure associated with 1 kiloohm resistors may be an array specifying 1003, 997.9, 998.3, 1001.8, 999.5, 999.3, 1001.96, 1001.03, 999.82, and 1000.58 as potential component values for the resistor.

Once a component value is selected (at 430), the selected component value is incorporated (440) into the circuit model in place of the nominal value. It is noted that the nominal value may not actually be included in the circuit model as originally acquired (at 400) as the component value but may instead be utilized as a label or other identifier. Accordingly, when reference is made to incorporating the selected component value in place of the nominal value (at 440), it is understood that such incorporation may be the first application of a component value to the corresponding component.

In some embodiments, once the circuit model is acquired 400, multiple components having variable values are identified (at 410). In some such embodiments, multiple components may have identical nominal values (identified at 420), and the method may then proceed to select multiple component values (at 430).

Accordingly, the method may identify, e.g., 3 resistors in the circuit model that each have a 1000 Ohm nominal value. Selections of component values for each component (at 430) may be simultaneous, in that the method may retrieve 3 values from the corresponding data structure, after which all 3 values are incorporated into the circuit model and applied to the corresponding components (at 440), or selection may be iterative, such that the method first selects a first selected component value (at 430), applies the same to a first component (at 440) and then determines whether additional components require component values (at 450). If additional components require values, the method may then return to the identification of a component having a variable value (at 410) and repeat the methodology described until all components have component values.

In such a scenario, where each of the plurality of components identified (at 410) have identical nominal values, the corresponding component values are typically drawn from the same data structure (at 430), but a different component value may be selected for each of the components.

Alternatively, the method may identify multiple components that have distinct nominal values (identified at 420). Accordingly, three resistors having different nominal values may be identified, or different component types may be identified. For example, the method may identify a resistor having a nominal value of 1000 Ohm and a capacitor having a 100 uF nominal value.

The method may then have distinct data structures associated with each nominal value and/or component type. Accordingly, in addition to the array described above, the database 114 or system memory 304 may have an array of 10 values associated with the 100 uF capacitor, such as: 101, 102, 104, 101, 106, 100, 102, 102, 100, 103. Accordingly, where nominal values or component categories are different, for each component, a component value is selected from a different plurality of potential component values associated with the corresponding nominal value.

Accordingly, the method may first select a value for the resistor from the array already described and may then select a value for the capacitor from the corresponding array. As discussed above with respect to multiple components having identical nominal values, such selection of values may be simultaneous or consecutive.

In the sample circuit shown in FIG. 4A, the circuit model includes 3 resistors, R1, R2, and R3, 4 capacitors, C1, C2, C3, and C4, an op amp A, and a variable resistor, or potentiometer, VR1. To the extent that multiple resistors have identical nominal values, such component values may be assigned simultaneously or consecutively.

In some embodiments, a single component may have a plurality of variable values. For example, in the context of a potentiometer, VR1, a plurality of component values may define detent locations or resistor values associated with corresponding detent locations. Accordingly, a 20,000 Ohm linear potentiometer with 21 detents would have 20 steps, each having a nominal value of 1000 Ohms. Accordingly, when at the first detent, the total resistance would have a nominal value of 1000 Ohms, when at the second detent, the total resistance would have a nominal value of 2000 Ohms, and so on.

Such a component having multiple nominal values may be modeled in a number of ways. In some embodiments, the potentiometer may be modeled in terms of detent locations, such that a single 20,000 Ohm value is broken up into components. In some embodiments, the detent values may be modeled individually, such that the first detent is modeled as a 1000 Ohm resistor, the second detent is modeled as a 2000 Ohm resistor and so on. In yet other embodiments, the detent values may be modeled as individual and summed resistances, such that each detent is provided with 1000 Ohms of resistance, and the values are added up in the model. In any event, each nominal value is associated with a plurality of potential component values from which a component value may be selected, and corresponding component values may be selected in the same manner as described above.

In the case of a potentiometer, when the nominal values are considered consecutively, the values notionally follow a taper, such that a minimum resistance is at one end and a maximum resistance is at another end. Such a taper may be nominally defined in various ways, such that a linear potentiometer is only one approach, while other potentiometer may be modeled as having logarithmic tapers. In some implementation modes, the tapers of the potentiometers may be idealized.

In some embodiments, at least one component identified (at 410) is non-linear, and may then have a behavior defined by a sub-model. For example, transformers and vacuum tubes may be more appropriately modeled as analytically generated sub-models. Such a sub-model may then have at least one internal variable value, and the selected nominal value is then associated with an internal variable value of the sub-model. Such a sub-model may then have multiple internal variable values which can be assigned simultaneously or consecutively, as described above.

In some embodiments, the components themselves (identified at 410) may have characteristics that vary over time, or which are themselves functions of time or some other factor. Accordingly, the first selected component value (at 430) may itself be a dynamic function of time. For example, the component value may be based on an oscillation generator. Similarly, the component value may vary to emulate thermal effects or component aging associated with use of a corresponding analog audio circuit.

In some embodiments, a component value selected may fluctuate pseudo-randomly. For example, the value may fluctuate based at a least partially based on generated audio output.

As discussed above, different system modes may allow for different levels of variance between components. Accordingly, the system may be configured for additional dynamic modulation around individual analog component values, such as by using real-time low-frequency oscillators (LFOs) to create an enhanced or exaggerated sense of movement often associated with analog gear. Further the system may include multiple dynamic modes. Further, modes may use any combination of tempo-synchronized or asynchronous oscillators of any simple or complex waveform. A single LED indicator may be included to visually represent the collective timing of modulations, or other GLTI presentations may be utilized as well.

Once a component value is applied to the selected component (at 440), or to all identified components, where multiple components have been identified, the method may proceed to generate an audio output (460) at least partially by processing audio by way of the circuit model. Such output may be generated and stored in a file, or it may be output by way of speakers 314.

As discussed above, the database 114 or system memory 304 are typically provided with data structures, each containing a plurality of potential component values associated with a given nominal value. Such data structures, which may be arrays associated with each nominal value, are then drawn on for selecting component values for identified components. Such data structures may be stored in a single database or may be maintained individually in discrete databases.

In some embodiments, a component having an identified nominal value can be assigned a component value drawn from different user selected databases or data structures. Such selection may depend on context or it may depend on an option selected by a user. For example, a single nominal value for a single component, such as a 1000 Ohm resistor, may be provided with a component value from either a first data structure or a second data structure. The first data structure may provide values associated with a first stock of virtual parts generated with a first tolerance and the second data structure may provide values associated with a second stock of virtual parts generated with a second tolerance.

Accordingly, A-stock components in the first data structure may have component values 1003, 997.9, 998.3, 1001.8, 999.5, 999.3, 1001.96, 1001.03, 999.82, 1000.58. In contrast, B-stock components in the second data structure may have component values 998.24, 1021.95, 1002.05, 996.503, 1000.25, 998.1, 997.937, 999.1, 999.9, 1001.1.

Accordingly, individual nominal values may be associated with multiple groups of potential component values, and a selection of a first data structure having a first plurality of component values or a second data structure having a second plurality of component values may depend on a system setting. Accordingly, a system setting, or a user option, may determine whether parts are drawn from A-stock or B-stock. In the example shown, the A-stock parts database or data structure provides potential component values for emulated components with tighter tolerances than the potential component values of the B-stock parts database or data-structure.

As noted above, the system described may provide users with various implementation options. These modes may include various static and dynamic realism modes, and they may exist along a spectrum in order to provide a user with options for selecting a degree to which variations may be introduced into the digital circuit model. The variation of parts in different modes may be more or less, and as such, some modes may utilize the A-stock component values while other modes may utilize B-stock component values.

Such part bin component values may be utilized in static realism modes, which may utilize fixed values for some or all variables that do not change over time. Further the plurality of static realism modes may include an ideal mode. Further, in some modes, component variables in the model may use nominal values from the analog circuit for all channels so that there is little or no variation throughout.

In some embodiments, the method includes populating the databases or data structures with potential component values. Accordingly, in some embodiments, the method may include retrieving a plurality of physical components (470) corresponding to a component having a variable value, such as the 1000 Ohm resistor described above. The physical components retrieved are manufactured in accordance with the nominal value, in this case 1000 Ohms.

Once a plurality of physical components (470) are retrieved, the actual values associated with those physical components are measured (480), and the plurality of potential component values may then be populated (490) based on the actual values measured.

In some embodiments, the plurality of potential component values may be populated (at 490) directly based on the measurements (at 480). In such embodiments, for example, a person implementing the method may retrieve and measure 10 components, and the measured values may then be the 10 potential component values in the data structure.

In some embodiments, plurality of potential component values may be populated (at 490) by generating a part value distribution model based on the actual values measured and extrapolating a larger plurality of potential component values (485) than those actually measured. Accordingly, after several values are measured, such values may be fit to a standard distribution, and a larger set of values may be generated from that distribution. As such, if 10 physical components are measured, for example, the virtual parts bin generated therefrom may contain hundreds or thousands of values.

In some embodiments, the first circuit model acquired (at 400) is one of a plurality of circuit models, and each circuit model corresponds to one of a plurality of audio channels. A second circuit model is then acquired (at 405) and is generally identical to the first circuit model. Accordingly, the first circuit model may be one audio channel, such as a left audio channel of stereo output and the second circuit model may be a second audio channel, such as a right audio channel of the stereo output. An example of such a second circuit model is shown in FIG. 4B.

Accordingly, in the example shown, FIG. 4A shows a left channel of a stereo system, with left inputs and outputs, while FIG. 4B shows a right channel of the same stereo system, with right inputs and outputs. As shown, the circuits are the same and may be provided with nominally identical components in corresponding locations within the circuit. However, real world implementations may result in slightly different values for equivalent components.

As in the case of the first circuit model, the method proceeds to identify (415), in the circuit model, at least one component having a variable value. Because the second circuit model (acquired at 405) is identical to the first circuit model (acquired at 400), the component identified (at 415) in the second circuit model may correspond to the component identified (at 410) in the first circuit model.

Once the component is identified, a corresponding nominal value associated with the variable value is identified (425). Typically, where the component identified in the second circuit model (at 415) is the same component as that identified in the first circuit model (410), the nominal value associated therewith (at 420) would be the same.

Once a nominal value is identified (at 425) for the identified component, a corresponding component value may be selected (435) from the plurality of potential component values associated with that particular nominal value. Where the component of the second circuit model has the same nominal value as that of the first circuit model, the plurality of potential component values associated with that particular nominal value may be the same. As discussed above with respect to the selection for the component of the first circuit (at 430), the selected component value (selected at 435) may differ from the nominal value.

The second selected component value may then be incorporated (445) into the circuit model in place of the nominal value, and the discussion above with respect to the incorporation (at 440) of the first selected component value into the first circuit model applies similarly to the second circuit model.

Accordingly, following the incorporation of the second selected component value (at 445), the method may proceed to evaluate whether additional components require component values (at 455), and the method may proceed to repeat the process described until all components have appropriate values.

Following the population of all values within the second circuit model, the method may proceed to generate an audio output (465) from the second circuit model. Where the first circuit model represents a first audio channel and the second circuit model represents a second audio channel, the two channels may work in concert to process audio input and generate stereo or other multi-channel output.

In some embodiments, and in some scenarios, rather than selecting component values (at 435) for the identified components of the second circuit model, the second selected component value may be determined to be identical to the first selected component value. Such a "symmetry" mode may be a system setting or it may be a user selected option. When such an option is applied, both channels may provide identical output given identical input. Alternatively, both circuit models may be provided with different values selected from the same pluralities of potential component values, thereby allowing for realistic variation between multiple channels within a single hardware device. It is noted that in FIG. 3, the selected component value (435) for the second circuit model is shown as drawn from the value selected for the first circuit model (430). This is for implementing symmetry mode, but it will be understood that the component value could similarly be drawn from the database 114 directly.

Accordingly, a symmetry mode may include a high amount of left/right symmetry because it uses identical digital models on both the left and right channels of a stereo instance. However, in some embodiments, variation may be introduced in specific places in the model. For instance, some detented potentiometer variables may use actual measured part values for each detent on each gang. This yields realistic and uneven detent spacing to give an imperfect analog feel. The taper of a real potentiometer often has an "S" shape rather than a straight line, and the measured values would capture this feature of real analog parts. In other embodiments, potentiometers may be idealized, since such idealized potentiometers may make it easier to master equalizations applications when maintaining perfect left/right image is desired while boosting or cutting frequencies.

Frequency response between channels would then be well matched in such a symmetry mode. Accordingly, applying a symmetry mode may give a user a realistic analog emulation, but with less stereo or instance-to-instance variation than other modes.

In the sample circuit shown in FIG. 4B, the circuit model includes 3 resistors, R4, R5, and R6, 4 capacitors, C5, C6, C7, and C8, an op amp B, and a variable resistor, or potentiometer, VR2. To the extent that multiple resistors have identical nominal values, such component values may be assigned simultaneously or consecutively. Further, in symmetry mode, all values may match the corresponding values of the circuit model shown in FIG. 4A exactly. For example, the component value assigned to resistor R1 may be used for R4, the component value assigned to resistor R2 may be used for R5, and the component value assigned to resistor R3 may be used for R6.

In some embodiments, following the assignment of component values to all components having variable values, the method may proceed to generate or assign an identifier, such as a virtual serial number (500), for the corresponding circuit model or audio device comprising multiple circuit models. Such a virtual serial number may correspond to an implementation of the first circuit model or audio device fully populated with component values. Accordingly, the implementation represented by the virtual serial number incorporates all selected component values.

Following the generation or assignment of the virtual serial number (at 500) to the circuit model or device, the virtual serial number is usable to generate an identical implementation of the circuit model or device in multiple implementations of software utilizing the computer-based method described. Accordingly, where a system or computing device 300 implements the method described here, it can be provided with a serial number prior to populating the circuit model. The serial number may be used to assign component values to all variable values.

Similarly, as shown in FIG. 1, in some embodiments, a serial number may be a starting point used by a user or a computing device 300 such that prior to acquiring the first circuit model (at 400) or prior to identifying and populating the variable values therein, the method retrieves a virtual serial number (510) and utilizes that virtual serial number to select component values from the corresponding pluralities of potential component values for each variable value.

It is understood that a virtual serial number 500, 510 is referenced. However, the number need be a true "serial number" and it need not be a number. Instead, any identifier that can uniquely be linked to a circuit implementation may be used.

In one embodiment, the virtual serial number 510 retrieved during the method to guide population of the circuit model may be used by using it as a seed for a pseudo-random number generator. This may, in turn, generate a map of indices by which the component values are selected.

In practice, a system implementing the method described, such as a computing device 300, may then provide a digital emulation of an analog device. Such a digital emulation may include a circuit model corresponding to an analog audio component. The circuit model then has a plurality of modeled analog components, such as resistors, capacitors, potentiometers, diodes, transistors, voltage-controlled amplifiers, transformers, and/or vacuum tubes.

Different instances of modeled components then have different corresponding nominal values. Accordingly, a first modeled analog component of the plurality may then have a corresponding first nominal value, and a second modeled analog component of the plurality may have a corresponding second nominal value. The two distinct components may be the same category of components having different nominal values, such as two resistors having different nominal values, or they may be distinct components from different categories, such as a resistor and a capacitor.

A first group of predefined potential component values is then provided associated with the first nominal value and a second group of predefined potential component values is provided associated with the second nominal value.

A digital emulator may then be provided for processing sounds using the circuit model.

When emulating the circuit model, the first modeled analog component is assigned a value selected from the first group, and the second modeled analog component is assigned a value selected from the second group.

Audio output by the digital emulator then utilizes the assigned values of the first and second modeled analog components.

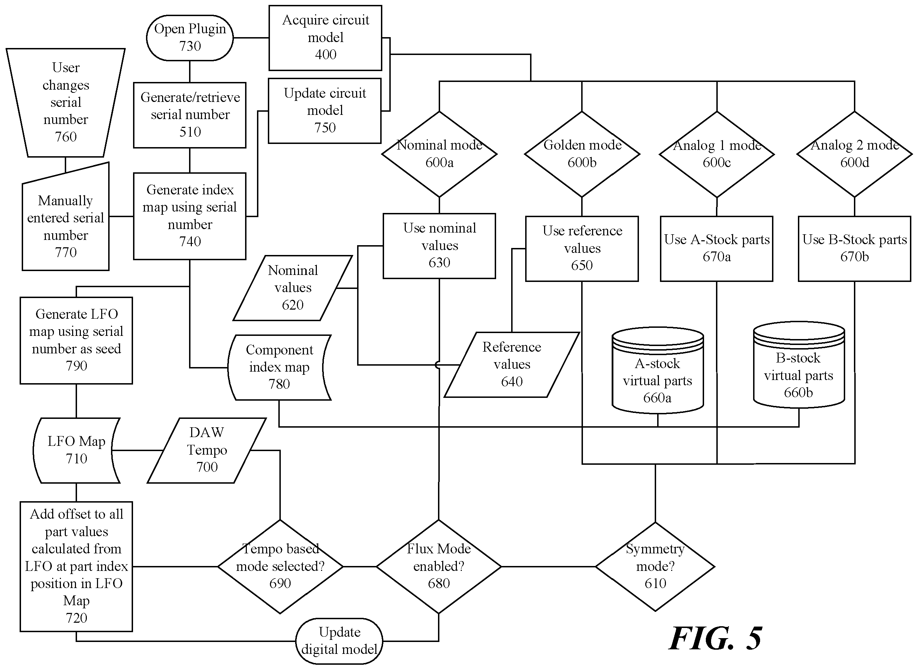

Figure 5 is a schematic illustration of an application 320 for generating and updating a digital circuit model for emulating audio in the context of audio plugins, in accordance with this disclosure, such as by using the methodology described above in reference to FIG. 3. Accordingly, the application 320 allows a user to select from a plurality of realism modes 600a, b, c, d, to control variations. Further, the plurality of realism modes provides users with a spectrum of analog realism options to explore. Further, the plurality of static realism modes may include an ideal mode, or nominal mode 600a, a golden mode 600b, a first analog mode (or analog1) 600c, and a second analog mode (or analog 2) 600d.

In a typical ideal or nominal mode 600a, component variables may use nominal values 620 from the analog circuit for all channel limit variations. Accordingly, in such a mode, the software application 320 may bypass much of the methodology described above in reference to FIG. 3 and simply generate or populate the circuit using the provided nominal component values 630.

Further, the plurality of realism modes 600a, b, c, d may exist along a spectrum to give the user options for selecting the degree to which variation may be introduced into the digital model. There may be more or less variation in different parts of the model for each mode. For example, in the ideal or nominal mode 600a, linear and logarithmic taper potentiometers may be idealized. Further, potentiometers with detents may include ideal resistances between each step. For example, a 20k linear potentiometer with 21 detents may include 1000 ohm steps.

Similarly, in the golden mode 600b, a specific hardware device or a golden device (i.e., idealized real world device) may be utilized. As such, the nominal values 620 may provide guidance as to which realistic reference values 640 are to be applied for every hardware instance. The circuit is then generated or populated with such reference values 650.

Further, in any of the non-idealized modes 600b, 600c, 600d, a symmetry mode 610, as described above, may be applied, resulting in a high amount of left/right symmetry. Further, the symmetry mode may utilize identical digital models on the left and right channels of a stereo instance. As discussed in the context of the method of FIG. 3, where symmetry mode 610 is active, the method may first select component values for a single channel and then apply similar or identical values to the second channel. Where symmetry mode 610 is not active, the method may instead implement a complete selection methodology for generating two independent channels.

Further, the first analog mode 600c may be an accurate emulation of a real hardware unit. Further, in the first analog mode 600c, the system may utilize the plurality of A-stock virtual parts bins 660a to assign values to all critical variables throughout the model. Accordingly, in analog 1 mode 600c, the circuit is generated or populated 670a with component values drawn from the A-stock virtual parts bin 660a.

Similarly, in the second analog mode 600d, the system may utilize the plurality of B-stock virtual parts bins 660b. As discussed above, the B-stock virtual parts bin 660b may contain simulated or emulated component values that vary more relative to a nominal values than the A-stock components. Accordingly, when a circuit is generated or populated 670b with component values drawn from the B-stock virtual parts bin 660b, such a circuit may emulate an out-of-spec hardware device. Further, in the second analog mode 600d, where symmetry mode 610 is not utilized, a variation between channels may be more exaggerated and may similarly be reminiscent of an out-of-spec hardware unit. In some embodiments, a multiplier may be applied to some variables to exaggerate the out-of-spec behavior even further.

Accordingly, the application 320 may include a plurality of static realism modes. The first analog mode 660c may be the most accurate emulation of the real hardware unit that was modeled. The application then uses the full group of virtual parts bins to assign values to all critical variables throughout the model. This may yield variations between individual potentiometer gangs and detents and variations between capacitor and resistor values that have been designated.

As a result, stereo imbalances may more accurately reflect reality. There may also be frequency response variations between the channels, primarily due to different resistances at each potentiometer detent, unless symmetry mode is selected.

Further, the application 320 may include virtual circuit components used by a digital signal processing (DSP) model to build unique versions/instances of the plugin for each user incorporating the variations.

Further, the system may include a plurality of dynamic realism modes. Further, the plurality of dynamic modes may use values for some or all variables that change over time. The starting point for the time-based variation is typically one of the static modes described above. Oscillation algorithms may then be applied to the variables to achieve the time-based variation.

The plurality of dynamic modes may include, but may not be limited to, fluctuating mode (or flux) 680. The fluctuating mode 680 may allow some or all variables to be modulated in a pseudo-randomized, but musical way as if the audio circuits themselves are moving or pulsing with the music. This is meant to both capture and surpass the subtle dynamic variations that occur in real analog hardware through thermal effects, or long-term component aging. With shorter oscillation periods and exaggerated amplitude ranges the digital model can generate a hyperreal emulation for the user to exploit creatively.

Controls may be added to the plugin GUI to control the Rate (period) and Depth (amplitude) of oscillations. The ranges of each control can be made as small or large as desired. Further, the plurality of dynamic realism modes may include a rate LED added to the plugin GUI to visualize the general speed of the fluctuation settings within the circuit. However, because such a Flux implementation may include a unique frequency calculated for every individual circuit component, specific GUI implementations may use a somewhat arbitrary fixed frequency for the visual LED, which is multiplied by the rate scalar the same way that the rest of the LFOs in the system are internal. Because of this, it may not correspond to the average or any individual LFO within the system but rather gives the user a dependable representative sense of the internal speed at any given setting.

For example, the LED flashes red at its maximum once per period, then turns blue and fades in and out as it oscillates up and down. Accordingly, the user interface may include a rate LED that allows the user to visualize the general speed of a fluctuation setting within a circuit associated with the emulated system.

Further, the fluctuating mode may include a digital audio workstation (DAW) synchronized mode (or sync) 690 to synchronize a rate of oscillations to a DAW tempo track 700, or the DAW synchronized mode may include a tempo based mode (or bpm). Further, in the DAW synchronized mode, the user may control the rate as a function of musical note divisions tied to the DAW tempo track.

Oscillation periods can occur at musical multiples of the set tempo. The rate LED described above is synchronized to a musical note division that tracks the progress within the DAW timeline so that each measure corresponds to a single oscillation of the LED and internal modulation values. Further, a variant of the above mode is one in which the user has control of the rate as a function of musical note divisions tied to the DAW tempo track. Instead of the rate control being free-running as it is in flux mode, or locked to the DAW tempo as it is in the sync mode, it would specify musical ratios to apply to the DAW tempo for oscillators assigned to variables. Obvious note divisions might include whole, half, quarter, eighth, and dotted eighth notes. For example, the DAW's time signature and tempo may be 4/4 and 120 bpm, respectively. If the rate control specifies half note, then an oscillator would operate with a 0.5 ratio corresponding to a rate of 60 bpm. Variables could all receive the same ratio or different ones that maintain some kind of musical relationship amongst themselves. In other words, it may be creatively interesting to apply multipliers to some ratios in specific parts of the model.

Further, the system may be configured for generating a near infinite number of unique plugin instances with accurate channel-to-channel, and instance-to-instance variations.

Further, the system may be configured for adding additional dynamic modulation around individual analog component values using real-time low-frequency oscillators (LFOs) to create an enhanced or exaggerated sense of movement often associated with analog gear. This may be by utilizing an LFO Map (710) which in turn is used to add offsets to part values calculated from the LFO at part index positions in the LFO map 720. This may be updated based on the emulated LFO at regular intervales until the flux mode 680 is disabled. Further, the system may include multiple dynamic modes.

Further, modes may use any combination of tempo-synchronized or asynchronous oscillators of any simple or complex waveform. A single LED indicator may be included to visually represent the collective timing of modulations.

During use, the application 320 is utilized by first opening the plugin 730. The system may then generate 500 or retrieve a serial number 510, which may then be used to generate an index map 740 to define characteristics of the circuit model when generating or updating such a model 750.

The serial number 510 may be generated 500 or retrieved in a number of ways. As discussed above with respect to the method of FIG. 3, the serial number may be generated 500 based on a previously defined build of a circuit model. Accordingly, upon opening the plugin (at 730), the method of FIG. 3 may be applied without a defined component index map by first acquiring a circuit model 400 and proceeding the populate the circuit model using the various modes described, as discussed above, and the resulting digital circuit model and corresponding values may then be utilized to generate a virtual serial number 510. Alternatively, a virtual serial number 510 may be generated from a customer number, or may be generated randomly upon initiating an instance of the software package.

As one example, to create a serial number associated with a single user, their account name may be converted to a string primitive, then sent through a hashing function converting it 20 to a 32-bit integer number. This may then be sent through a modulo function to guarantee that the value stays within the maximum allowable number of serial numbers (e.g., 999,999).

Further, the serial number may then be used as the seed for a Mersenne Twister 19937 pseudo-random number generator, which is used to calculate a map of indices by which parts in the parts bin are selected for each portion of the statically modeled analog circuit. This map may then be an array of integer values, the size of which is determined by the number of parts selected for variance throughout the circuit. The value of each index within this map is capped at the number of parts in the virtual parts bin for that index. For example, 10 "A-stock" and 10 "B-stock" allowing 20 in total for each unique component. This capping may be done using a modulo function on the pseudo-random value provided by the Mersenne Twister 19937 generator.

Where the same component is used multiple times throughout the circuit, they will usually have different map values for each instance, meaning that the final value for each part is slightly different. The use of the Mersenne Twister 19937 generator guarantees that the same map will be calculated between machines for the same serial number, ensuring that the sound will be identical, just as if the user was using the same hardware box with its own unique selection of parts.

Alternatively, a virtual serial number 510 may be defined directly by a user. Accordingly, in some embodiments, the user may change the serial number 760, or may otherwise manually enter the serial number 770, such that the serial number is provided to the application 320.

In any event, once a serial number is acquired, the application 320 may be configured for generating an index map 740 using the serial number as, for example, a seed to a pseudo-random number generator.

Once an index map is generated, a user may select one of the various system modes 600a, b, c, d discussed above. Alternatively, such modes may be implemented without the initial generation of an index map.

Where an index map is used to generate a circuit implementation based on a serial number 510 (at 740), such an index map may be include a component index map 780, which may in turn be used to guide the selection of specific component values from one or both of the A-stock and B-stock virtual parts bins 660a, b, depending on which mode is utilized by a user.

Further, a set of all selected component variable values may be linked to a user plugin license associated with a user via a virtual serial number to create a unique build for the user, as discussed above.

For static modes, in some embodiments, the digital model is calculated once from the map created for the serial number whenever it is initialized or changed. It is then kept fixed until the user changes either the serial number or the realism model. For dynamic modes, a modulation is added to each internal component value, requiring the model to be updated continually in real-time as described below.

As discussed above, an LFO Map (710) may be used to add offsets to part values calculated from the LFO at part index positions in the LFO map 720. In some such embodiments, such an LFO map may be generated (790) from the serial number 510 or from the index map generated from the virtual serial number 510.

In some implementations of flux mode 680, an LFO may be added to many or every component within the circuit. Each LFO may then have a unique pseudo-randomly calculated frequency, amplitude, and phase-offset value determined by the serial number in use. For some implementations, all oscillators are cosine wave-shaped oscillators. However, any other shapes may be used, for instance, square, sawtooth, triangle, or more complex wavetables. Further, during processing, these LFOs modulate at rates determined by their frequency multiplied by a user-changeable "rate" scalar, allowing the entire system to be slowed or quickened as desired. A "depth" scalar may be controlled through a second knob, causing all LFO amplitudes to be scaled in magnitude. Rate and Depth values may be interpolated over multiple frames whenever they are changed to prevent audible "zipper" or noise.

In order to reduce computational load, LFO values may only calculated for sections of the circuit that are active and may be updated at a reduced downsampled rate using system time differences between frames, computed once at the start of a buffer to prevent any offsets or aliasing being introduced by processing time within the analog modeling calculations.

The same Mersenne Twister 19937 generator may be used to initialize these LFOs, meaning that serial numbers also determine a unique modulation "thumbprint," or the rate, amplitude, and phase of all modulations within the system.

While the embodiment described herein relates generally to the creation of a unique analog circuit emulation in the domain of audio plugins, the association of a user's unique ID with a pseudo-random seed may also be applied to other types of software. For example, in the realm of game development, a user's license number could be utilized to modify characteristics of a procedurally generated game world. Accordingly, a parts map as described above could be calculated and applied as parameters of generative algorithms used to build such a world's environmental features, biology, history, and/or characters.

By leveraging the license number as a seed for pseudo-random number generation, the system can ensure that each user is presented with a distinct version of the game and resulting interactions. This could potentially enhance user engagement, providing an exclusive, personalized experience and sense of ownership. The overarching principle is the creation of a bespoke version of the software for each user-assigned or manually selected license key, inspired by component variations introduced through in the production process of analog hardware.

The term "data processing apparatus" and like terms encompass all kinds of apparatus, devices, and machines for processing data, including by way of example a programmable processor, a computer, a system on a chip, or multiple ones, or combinations, of the foregoing. The apparatus can include special purpose logic circuitry, e.g., an FPGA (field programmable gate array) or an ASIC (application specific integrated circuit). The apparatus can also include, in addition to hardware, code that creates an execution environment for the computer program in question, e.g., code that constitutes processor firmware, a protocol stack, a database management system, an operating system, a cross-platform runtime environment, a virtual machine, or a combination of one or more of them. The apparatus and execution environment can realize various different computing model infrastructures, such as web services, distributed computing and grid computing infrastructures.

A computer program (also known as a program, software, software application, script, or code) can be written in any form of programming language, including compiled or interpreted languages, declarative or procedural languages, and it can be deployed in any form, including as a standalone program or as a module, component, subroutine, object, or other unit suitable for use in a computing environment. A computer program may, but need not, correspond to a file in a file system. A program can be stored in a portion of a file that holds other programs or data (e.g., one or more scripts stored in a markup language document), in a single file dedicated to the program in question, or in multiple coordinated files (e.g., files that store one or more modules, sub programs, or portions of code). A computer program can be deployed to be executed on one computer or on multiple computers that are located at one site or distributed across multiple sites and interconnected by a communication network.

The processes and logic flows described in this specification can be performed by one or more programmable processors executing one or more computer programs to perform actions by operating on input data and generating output. The processes and logic flows can also be performed by, and apparatus can also be implemented as, special purpose logic circuitry, e.g., an FPGA (field programmable gate array) or an ASIC (application specific integrated circuit).

Processors suitable for the execution of a computer program include, by way of example, both general and special purpose microprocessors, and any one or more processors of any kind of digital computer. Generally, a processor will receive instructions and data from a read only memory or a random access memory or both. The essential elements of a computer are a processor for performing actions in accordance with instructions and one or more memory devices for storing instructions and data. Generally, a computer will also include, or be operatively coupled to receive data from or transfer data to, or both, one or more mass storage devices for storing data, e.g., magnetic, magneto optical disks, or optical disks. However, a computer need not have such devices. Moreover, a computer can be embedded in another device, e.g., a mobile telephone, a personal digital assistant (PDA), a mobile audio or video player, a game console, a Global Positioning System (GPS) receiver, or a portable storage device (e.g., a universal serial bus (USB) flash drive), to name just a few. Devices suitable for storing computer program instructions and data include all forms of non volatile memory, media and memory devices, including by way of example semiconductor memory devices, e.g., EPROM, EEPROM, and flash memory devices; magnetic disks, e.g., internal hard disks or removable disks; magneto optical disks; and CD ROM and DVD-ROM disks. The processor and the memory can be supplemented by, or incorporated in, special purpose logic circuitry.

To provide for interaction with a user, embodiments of the subject matter described in this specification can be implemented on a computer having a display device, e.g., a CRT (cathode ray tube) or LCD (liquid crystal display) monitor, for displaying information to the user and a keyboard and a pointing device, e.g., a mouse or a trackball, by which the user can provide input to the computer. Computers may further be provided in other forms, such as in the form of handheld devices or smartphones, as well as in the form of tablet devices. Other kinds of devices can be used to provide for interaction with a user as well; for example, feedback provided to the user can be any form of sensory feedback, e.g., visual feedback, auditory feedback, or tactile feedback; and input from the user can be received in any form, including acoustic, speech, or tactile input. In addition, a computer can interact with a user by sending documents to and receiving documents from a device that is used by the user; for example, by sending web pages to a web browser on a user's client device in response to requests received from the web browser. A device for providing interaction with a user may be referred to as a user interface device.

Embodiments of the subject matter described in this specification can be implemented in a computing system that includes a back end component, e.g., as a data server, or that includes a middleware component, e.g., an application server, or that includes a front end component, e.g., a client computer having a graphical user interface or a Web browser through which a user can interact with an implementation of the subject matter described in this specification, or any combination of one or more such back end, middleware, or front end components. The components of the system can be interconnected by any form or medium of digital data communication, e.g., a communication network. Examples of communication networks include a local area network ("LAN") and a wide area network ("WAN"), an inter-network (e.g., the Internet), and peer-to-peer networks (e.g., ad hoc peer-to-peer networks).

The computing system can include clients and servers. A client and server are generally remote from each other and typically interact through a communication network. The relationship of client and server arises by virtue of computer programs running on the respective computers and having a client-server relationship to each other. In some embodiments, a server transmits data (e.g., an HTML page) to a client device (e.g., for purposes of displaying data to and receiving user input from a user interacting with the client device). Data generated at the client device (e.g., a result of the user interaction) can be received from the client device at the server.

While this specification contains many specific implementation details, these should not be construed as limitations on the scope of any inventions or of what may be claimed, but rather as descriptions of features specific to particular embodiments of particular inventions. Certain features that are described in this specification in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

While the present invention has been described at some length and with some particularity with respect to the several described embodiments, it is not intended that it should be limited to any such particulars or embodiments or any particular embodiment, but it is to be construed with references to the appended claims so as to provide the broadest possible interpretation of such claims in view of the prior art and, therefore, to effectively encompass the intended scope of the invention. Furthermore, the foregoing describes the invention in terms of embodiments foreseen by the inventor for which an enabling description was available, notwithstanding that insubstantial modifications of the invention, not presently foreseen, may nonetheless represent equivalents thereto.

## Claims

1. A computer-based method of introducing variability into digitally modeled circuits comprising:
acquiring a first circuit model corresponding to an audio circuit;
identifying, in the first circuit model, at least one component having at least one variable value;
identifying a nominal value associated with the at least one variable value of the at least one component;
selecting a first selected component value from a plurality of potential component values associated with the nominal value for the at least one variable value, wherein the first selected component value differs from the nominal value;
incorporating the first selected component value into the first circuit model in place of the nominal value;
generating an audio output at least partially by processing audio by way of the first circuit model.

2. The computer-based method of claim 1, wherein the at least one component is a resistor, capacitor, potentiometer, diode, transistor, voltage-controlled amplifier, transformer, or vacuum tube.

3. The computer-based method of claim 2, wherein the at least one component is a plurality of components, each associated with an identical nominal value, and wherein a different component value is selected for each of the plurality of components.

4. The computer-based method of claim 2, wherein the at least one component is a plurality of components, each associated with different nominal values, and wherein for each component of the plurality of components, a component value is selected from a different plurality of potential component values associated with the corresponding nominal value.

5. The computer-based method of claim 2, wherein the at least one component is non-linear with a behavior defined by a sub-model having at least one internal variable value, and wherein the selected nominal value is associated with an internal variable value of the sub-model.

6. The computer-based method of claim 1 further comprising providing a plurality of databases or data structures, each containing a plurality of potential component values associated with a given nominal value, and wherein a selection of a first of the plurality of databases or data structures or a second of the plurality of databases or data structures is based on a system setting.

7. The computer-based method of claim 6, wherein the first of the plurality of databases or data structures corresponds to an A-stock parts database or data structure and wherein the second of the plurality of databases or data structures corresponds to a B-stock parts database or data structure, and wherein the A-stock parts database or data-structure provides potential component values for emulated components with tighter tolerances than the potential component values of the B-stock parts database or data-structure.

8. The computer-based method of claim 1 further comprising:
retrieving a plurality of physical components corresponding to the at least one component having at least one variable value and manufactured in accordance with the nominal value,
measuring actual values associated with the plurality of physical components; and
populating the plurality of potential component values based on the actual values measured.

9. The computer-based method of claim 8, wherein the populating of the plurality of potential component values based on the actual values measured further comprises generating a part value distribution model based on the actual values measured and extrapolating a larger plurality of potential component values than those actually measured.

10. The computer-based method of claim 1, further comprising:
acquiring a device model comprising a plurality of circuit models, each corresponding to one of a plurality of audio channels;
wherein the first circuit model is one of the plurality of circuit models,
and wherein a second circuit model of the plurality of circuit models is identical to the first circuit model;
identifying, in the second circuit model, at least one component having at least one variable value, the at least one component of the second circuit model corresponding to the at least one component of the first circuit model;
identifying the nominal value associated with the at least one variable value;
selecting a second selected component value from the plurality of potential component values associated with the nominal value, wherein the second selected component value differs from the nominal value;
incorporating the second selected component value into the second circuit model in place of the nominal value;
generating an audio output by processing audio by way of the second circuit model.

11. The computer-based method of claim 10, wherein a user setting determines whether the second selected component value is identical to the first selected component value.

12. The computer-based method of claim 1 further comprising:
identifying at least one additional component having at least one variable value and for each variable value identified:
identifying a nominal value associated with the corresponding variable value;
selecting a component value for the corresponding variable value from a plurality of potential component values associated with the nominal value; and
incorporating the corresponding selected component value into the first circuit model in place of the nominal value,
wherein, following the incorporation of selected component values into the first circuit model, all variable values are provided with corresponding component values.

13. The computer-based method of claim 12 further comprising:
generating a virtual serial number associated with the first circuit model, the virtual serial number corresponding to an implementation of the first circuit model incorporating all selected component values, and
wherein the virtual serial number is usable to generate an identical implementation of the first circuit model in multiple implementations of software utilizing the computer-based method.

14. The computer-based method of claim 12 further comprising retrieving a virtual serial number and utilizing the serial number to select the component values from the corresponding pluralities of potential component values for each variable value.

15. The computer-based method of claim 14, wherein the virtual serial number is used as a seed for a pseudo-random number generator which in turn generates a map of indices by which the component values are selected.

16. The computer-based method of claim 1, wherein the first selected component value is a dynamic function of time.

17. A system for introducing variability into digitally modeled circuits comprising:
a memory for storing a plurality of instructions and at least one circuit model;
processing circuitry for implementing a first circuit model of the at least one circuit model;
an audio output for outputting audio generated by the first circuit model; and
a plurality of databases or data structures, each database or data structure corresponding to a nominal value for a circuit component and comprising a plurality of potential component values for a corresponding variable,
wherein the processing circuitry couples with the memory and the plurality of databases or data structures, and is configured to:
identify, in the first circuit model, at least one component having at least one variable value;
identify a nominal value associated with the at least one variable value of the at least one component;
select a database or data structure based on the identified nominal value;
select a first selected component value from the plurality of potential component values in the selected database or data structure; and
incorporate the first selected component value into the first circuit model in place of the nominal value;
wherein the audio generated by the first circuit model is at least partially based on the first selected component value.

18. A digital emulation of an analog device recorded on computer readable media comprises:
a circuit model corresponding to an analog audio component, the circuit model having a plurality of modeled analog components, wherein a first modeled analog component of the plurality of modeled analog components has a corresponding first nominal value and wherein a second modeled analog component of the plurality of modeled analog components has a corresponding second nominal value;
a first group of predefined potential component values associated with the first nominal value; and
a second group of predefined potential component values associated with the second nominal value;
an audio plugin for processing sounds using the circuit model;
wherein the first modeled analog component is assigned a value selected from the first group and wherein the second modeled analog component is assigned a value selected from the second group;
wherein audio output by the audio plugin utilizes the assigned values of the first and second modeled analog components.
